# EUROPEAN PATENT APPLICATION

(11) **EP 0 637 875 A1**
(43) Date of publication of application: **08.02.1995**
(21) Application number: 94110941.5
(22) Date of filing: 14.07.1994
(51) Int. Cl.: H03K 17/689, H03K 17/722, H01L 41/107

(54) **Acoustical isolator and method therefor**

(30) Priority: 04.08.1993 US 102174
(71) Applicant: MOTOROLA, INC., Schaumburg, IL 60196 (US)
(72) Inventor: Gempe, Horst A., Phoenix, Arizona 85028 (US)
(74) Representative: Hudson, Peter David

(57) **Abstract**

A method for electrically isolating a first circuit (11) from a second circuit (12). The first and second circuits (11,12) are non-electrically coupled together. A first piezo-electric device (13), an acoustic medium (16), and a second piezo-electric device (14) forms an acoustic isolator (19). The first piezo-electric device (13) couples to the first circuit (11) and the second piezo-electric device (14) couples to the second circuit (12). For example, an electric signal from the first circuit (11) is converted to a mechanical vibration by the first piezo-electric device (13). The mechanical vibration is transmitted through the acoustic medium (16) to the second piezo-electric device (14) where it is reconverted to an electric signal that is received by the second circuit (12). The acoustic isolator (19) decouples the first and second circuits (11,12) electrically, yet allows the transfer of acoustic energy.

## Description

### Background of the Invention

This invention relates, in general, to isolators for electronic circuits, and more particularly to an acoustical isolator for electronic circuits.

Optical isolators are commonly used to electrically isolate two separate or independent circuits. An example where isolation is commonly used is when one circuit operates at a high voltage (example-110 VAC) and the other at a low voltage (example-5 VDC). Another example where isolation is necessary is when two circuits have different ground potentials, an isolator will prevent ground loop problems. An optical isolator used in this circumstance would transfer a signal optically, with the signal being converted to an electronic signal by the receiving circuit. The problem with optical isolators is that optical coupling is extremely inefficient in the transfer of power. For example, a light emitting diode (LED) of a simple optocoupler may use 10 milliamperes to generate an optical signal while the detector diode sensing the light emitted by the LED may generate 10 microamperes. The low output by an optocoupler is not sufficient for many applications and may cause additional circuitry to be needed.

Isolators, in general, must meet rigorous standards due to the potential hazards that a high voltage circuit presents. The isolator must be able to meet specific criteria for packaging, electrical isolation, and internal creepage to name only a few. It would be of great benefit if an isolator could be provided which is efficient in power transfer yet provides adequate electrical isolation.

### Summary of the Invention

Briefly stated, this invention comprises a method for electrically isolating a first circuit from a second circuit. The first and second circuits are non-electrically coupled to one another. The method couples the first and second circuits acoustically with piezo-electric devices for transmitting and receiving a mechanical vibration.

### Brief Description of the Drawings

FIG. 1 is a diagram of two electrically isolated circuits coupled together through an acoustic isolator in accordance with the present invention; and
FIG. 2 is a schematic of a circuit application for an acoustic isolator in accordance with the present invention.

### Detailed Description of the Drawings

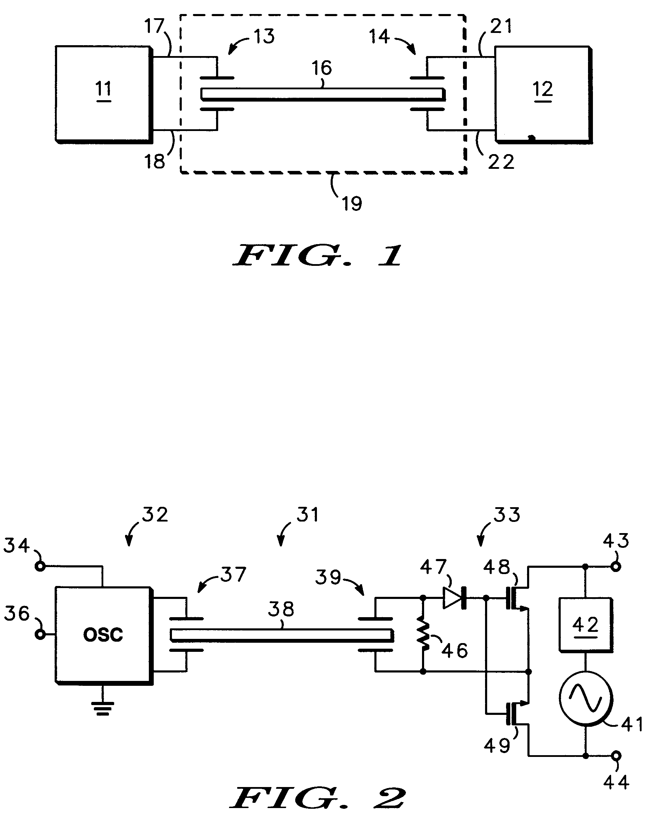

FIG. 1 is a diagram of a circuit 11 acoustically coupled through an acoustic isolator 19 to a circuit 12. Circuits 11 and 12 are electrically isolated from one another.

Many applications exist where circuits need to be electrically isolated from one another, yet a non-electrical interface must be provided to link the circuits together. An example, is a control circuit and a solid state relay. The solid state relay is typically coupled to a potentially hazardous voltage and thus must be electrically decoupled from the control circuit. A well known circuit isolator is an optical isolator (opto-isolator). Opto-isolators are extremely effective at providing electrical isolation but are inefficient in energy transfer. This inefficiency does not allow an opto-isolator to drive anything but a high impedance load which limits its usefulness for some applications or causes additional circuitry to be needed. Opto-isolators typically need some form of amplification to increase output drive. Acoustic isolator 19 provides similar electrical isolation as an opto-isolator and transfers energy efficiently.

Circuit 11 and circuit 12 are electrically isolated circuits. Acoustic isolator 19 couples circuit 11 and circuit 12 together acoustically with a mechanical vibration which corresponds to an electrical signal. The mechanical vibration can be from circuit 11 to circuit 12 or vice versa. For example, circuit 11 has a terminal 17 and a terminal 18 for providing an electrical signal to acoustic isolator 19 and circuit 12 has a terminal 21 and a terminal 22 for receiving an electrical signal from acoustical isolator 19. Acoustic isolator 19 converts the electrical signal provided by circuit 11 to a mechanical vibration, thus circuit 11 is electrically decoupled from circuit 12.

In the preferred embodiment, acoustic isolator 19 is a piezo-electric structure comprising a piezo-electric device 13, an acoustic medium 16, and a piezo-electric device 14. In the example described above, the electrical signal provided by circuit 11 is converted by piezo-electric device 13 to a mechanical vibration that corresponds to the electrical signal. In the preferred embodiment, the electrical signal has a predetermined frequency coinciding with the resonant frequency of piezo-electric device 13 to maximize energy transfer. Acoustic medium 16 provides a low loss path in which the mechanical vibration travels until it couples to piezo-electric device 14. Acoustic medium 16 is typically ceramic, plastic, rubber compounds, or other vibration transmitting materials. The mechanical vibration is converted to an electrical signal by piezo-electric device 14 and received by circuit 12. Piezo-electric device 14 is chosen to have a resonant frequency coinciding with the mechanical vibration frequency to maximize energy transfer. One type of acoustic device may be a piezo ceramic resonant filter, for example.

Acoustic medium 16 provides other benefits besides mechanical coupling. Acoustic medium 16 provides a physical distance between piezo-electric devices 13 and 14 to help meet isolator parameters such as isolation barrier or internal creepage. Acoustic medium 16 can also be designed to filter out unwanted mechanical vibration frequencies to decrease noise. In the preferred embodiment, piezo-electric device 13, acoustic medium 16, and piezo-electric device 14 are formed together as a unit that can be packaged, having leads for coupling to circuits 11 and 12.

Piezo-electric devices are significantly more efficient in the transfer of energy than optical coupling (light emitting diode to photo detector diode). Input to output power transfer can be as high as 50 percent for piezo-electric devices versus 0.1 percent for optical coupling. High efficiency power transfer allows acoustic isolator 19 to directly drive circuitry (although the circuits are electrically decoupled).

FIG.2 is a schematic of a circuit application for an acoustic isolator 31.

A circuit 32 and a circuit 33 are electrically isolated from each other but acoustically coupled through acoustic isolator 31. Circuit 32 is an oscillator for providing an electric signal of a predetermined frequency to acoustic isolator 31. Circuit 32 is powered by applying a supply voltage to input 34 and enabled by an enable signal applied to input 36.

Acoustic isolator 31 is similar to acoustic isolator 19 of FIG. 1 and comprises a piezo-electric device 37, an acoustic medium 38, and a piezo-electric device 39. Input to output voltage and currents are determined by electrode shape and area of acoustic isolator 31 (piezo-electric devices 37 and 38 listed above). It is important to note that this fact allows acoustic isolator 31 to be tailored for a specific application. The resonant frequency (or frequencies) is determined in part by the physical dimensions of acoustic isolator 31. Acoustic isolator 31 will optimally transfer energy at the resonant frequency (or frequencies). In the preferred embodiment, the predetermined frequency provided by circuit 32 is a resonant frequency of acoustic isolator 31. Piezo-electric device 37 generates a mechanical vibration which is coupled to acoustic medium 38. The mechanical vibration is then received by piezo-electric device 39 and reconverted to an electric signal which is received by circuit 33.

Piezo-electric devices 37 and 39 can be modeled as a resonator or tuned circuit. Energy transmission or energy reception is maximized at the resonant frequency of piezo-electric devices 37 and 39. Acoustic medium 38 can also be a tuned circuit. The physical dimensions and the physical characteristics of acoustic medium 38 determine frequencies in which the transfer of mechanical vibrations are optimized. In the preferred embodiment, acoustic medium 38 is designed to be a narrow bandpass filter, tuned for the mechanical vibration generated by piezo-electric device 37.

Circuit 33 is a solid state relay that couples an AD or DC voltage supply 41 to a load 42. Voltage supply 41 typically supplies a potentially hazardous voltage that necessitates the decoupling of circuits 32 and 33. Voltage supply 41 and load 42 are coupled between a terminal 43 and a terminal 44 of circuit 33. A load resistor 46 is coupled across piezo-electric device 39. Depending on the specific application it may or may not be necessary to provide a defined load impedance across piezo-electric device 39. A diode 47 is used to rectify the voltage signal generated across load resistor 46. The rectified voltage enables series coupled power transistors 48 and 49 to couple voltage supply 41 to load 42.

The current capability of acoustic isolator 38 is a function of its physical dimensions, frequency of transmission, and power inserted. The current magnitude can be made sufficient to directly drive circuitry without the need of additional circuitry. For example, a current generated in the 1-10 milliampere could be produced by piezo-electric device 37, acoustic medium 38, and piezo-electric device 39. Eliminating circuitry substantially reduces cost and complexity. Acoustic isolator 38 has dimensions suitable for housing in a semiconductor package. It is also possible to integrate acoustic isolator 38 with other circuitry using integrated circuit process.

By now it should be appreciated that a method for electrically isolating circuits has been provided which allows the circuits to be coupled acoustically.

## Claims

1. A method for coupling a first circuit (11) and a second circuit (12) wherein the first circuit (11) operates at a voltage at least one order of magnitude greater than the second circuit (12), the method comprising
coupling the first circuit (11) and the second circuit (12) acoustically to electrically isolate the first (11) and second (12) circuits from one another; and
spacing the first (11) and second (12) circuits a predetermined distance from one another.

2. A method as recited in claim 1 wherein said step of coupling acoustically includes:
converting an electrical signal from the first circuit (11) to a mechanical vibration corresponding to said electrical signal;
transferring said mechanical vibration through an acoustic medium (16); and
converting said mechanical vibration to an electrical signal.

3. A method as recited in claim 2 wherein said step of converting an electrical signal to a mechanical vibration includes:
coupling said electrical signal from the first circuit (11) to a piezo-electric device (13); and
generating said mechanical vibration with said piezo-electric device (13).

4. A method as recited in claim 3 wherein said step of generating said mechanical vibration with said piezo-electric device (13) includes
operating said piezo-electric device (13) at a resonant frequency to maximize energy transfer to said acoustic medium (16).

5. A method as recited in claim 2 wherein said step of transferring includes
filtering out unwanted mechanical vibrations.

6. A method as recited in claim 5 wherein said step of filtering output unwanted mechanical vibrations includes,
forming said acoustic medium (16) having bandpass filter characteristics for passing said mechanical vibrations.

7. A method as recited in claim 2 wherein said step of converting said mechanical vibration to an electrical signal includes:
coupling said mechanical vibration to a piezo-electric device (14); and
generating said electrical signal converted from said mechanical vibration with said piezo-electric device (14).

8. A method for electrically isolating a first circuit (11) from a second circuit (12) wherein the first (11) and second (12) circuits are non-electrically coupled, the method comprising:
coupling acoustically the first (11) and second (12) circuits with piezo-electric devices (13,14) for transmitting and receiving a mechanical vibration through an acoustic medium (16), said acoustic medium (16) electrically isolating the first circuit (11) from the second circuit (12) and physically spacing the first (11) and second (12) circuits a predetermined distance from one another.

9. A method as recited in claim 8 wherein said step of coupling acoustically includes:
converting an electrical signal from the first circuit (11) to said mechanical vibration with a first piezo-electric device (13);
transmitting said mechanical vibration through said acoustic medium (16);
receiving said mechanical vibration with a second piezo-electric device (14); and
converting said mechanical vibration to an electrical signal with said second piezo-electric device (14) wherein said second electrical signal is received by the second circuit (12).

10. A method for electrically isolating a first circuit (11) from a second circuit (12), the method comprising:
applying a first electrical signal from the first circuit (11) to a first piezo-electric device (13);
generating a mechanical vibration corresponding to said first electrical signal with said first piezo-electric device (13);
transmitting said mechanical vibration through an acoustic medium (16) to a second piezo-electric device (14), said acoustic medium electrically isolating the first circuit from the second circuit and physically spacing the first and second circuits a predetermined distance from one another;
generating a second electrical signal from said mechanical vibration with said second piezo-electric device (14);
applying said second electrical signal from said second piezo-electric device (14) to the second circuit (12), said first circuit (11) operating at a voltage substantially greater than an operating voltage of the second circuit (12).
